# EUROPÄISCHE PATENTSCHRIFT

(11) **EP 1 884 576 B1**
(45) Veröffentlichungstag und Bekanntmachung des Hinweises auf die Patenterteilung: **12.09.2012**
(21) Anmeldenummer: 07014730.1
(22) Anmeldetag: 26.07.2007
(51) Int. Cl.: C23C 14/56, C23C 14/50, C23C 16/458, C23C 4/14

(54) **Vorrichtung zur Plasmabeschichtung von länglichen, zylindrischen Bauteilen**
Device for plasma coating of long, cylindrical components
Dispositif destiné au revêtement par plasma de composants longitudinaux et cylindriques

(30) Priorität: 26.07.2006 DE 102006035259
(43) Veröffentlichungstag der Anmeldung: 06.02.2008
(73) Patentinhaber: Dr. Laure Plasmatechnologie Gmbh, 70329 Stuttgart (DE)
(72) Erfinder: Laure, Stefan, Dr., 70329 Stuttgart (DE)
(74) Vertreter: Geitz Truckenmüller Lucht

(56) Entgegenhaltungen:
- WO-A-02/07952
- JP-A- 63 100 181
- US-A- 2 858 122
- US-A- 4 123 316
- US-A- 4 814 056
- US-A- 5 560 779
- US-A1- 2003 002 958

## Beschreibung

### Stand der Technik

Die Erfindung geht aus von einer Vorrichtung zur Plasmabeschichtung von länglichen, zylindrischen Bauteilen, insbesondere von rohrförmigen Bauteilen.

Wird die Oberfläche eines Bauteils einem Plasma ausgesetzt, so können bei entsprechender Wahl der Plasmaparameter wie Druck, Temperatur und Plasmazusammensetzung die Funktionalität und die Eigenschaften der Oberfläche gezielt beeinflusst und verändert werden. Aus dem Stand der Technik sind Verfahren zur Behandlung, Modifizierung oder Beschichtung einer Oberfläche aus beliebigem Material bekannt, bei denen Teilchen- oder Energieströme aus einem Plasma genutzt werden. Hierzu zählen unter anderem Plasmaspritzen, Lichtbogenplasmaschmelzen, Plasmawärmebehandlungsverfahren, Plasma-CVD-Verfahren und Plasmareinigung. Die Veränderung der Funktionalität von Werkstückoberflächen erfolgt durch gezielten Angriff von Plasmateilchen. Dies kann durch die Wechselwirkung mit Teilchen mit bestimmten chemischen Eigenschaften oder durch die Einwirkung von Strahlung, die vom Plasma emittiert wird, geschehen. Bei Verfahren zur Plasmabeschichtung eines Bauteils wird der Beschichtungswerkstoff durch Zufuhr von Energie in den dampfförmigen oder gasförmigen Zustand versetzt und aus der Dampf- oder Gasphase auf dem Bauteil abgeschieden.

Zur Erzeugung eines Plasmas wird ein Plasmabrenner verwendet. Beim Lichtbogen-Plasmabrenner wird ein strömendes Gas durch einen Lichtbogen ionisiert und auf Temperaturen von 10.000 bis 20.000 K aufgeheizt. Beim Hochfrequenz-Plasmabrenner wird das strömende Gas durch Anlegen eines hochfrequenten elektromagnetischen Feldes an eine zylindrische Spule ionisiert. In einem zylindrischen Entladungsgefäß, welches aus einem dielektrischen Material gefertigt ist, entsteht ein relativ dichtes Plasma mit hoher Energiedichte. Auch hier können Plasmatemperaturen von bis zu 20.000 K erreicht werden, Beim Lichtbogenplasmabrenner und beim Hochfrequenzplasmabrenner handelt es sich um Geräte zur Plasmaerzeugung, die einen gerichteten Freistrahl erzeugen. Darüber hinaus existieren noch eine Vielzahl von Verfahren und Verfahrensvarianten, wie PVD Physical Vapor Deposition und CVD Chemical Vapor Deposition, die eine Beschichtung aus der Gasphase auf einem Werkstück abscheiden. In vielen Fällen wird dabei das Beschichtungsmaterial quellförmig in den Beschichtungsraum gegeben.

In einem Plasma können Bauteile oder Werkstücke mit bestimmten Materialien beschichtet, an ihrer Oberfläche gereinigt, aktiviert oder bearbeitet werden. Um dabei eine Verunreinigung des Werkstücks zu verhindern, erfolgt die Bearbeitung im Vakuum. Hierzu wird das Bauteil in eine Prozesskammer eingebracht. Diese wird anschließend verschlossen und unter Verwendung einer oder mehrerer Pumpen evakuiert.

Das Plasma tritt nur in einem eng begrenzten Bereich auf und bildet sich bei länglichen, zylindrischen Bauteilen nicht über das gesamte Bauteil aus. Zur Plasmabehandlung der gesamten Oberfläche eines länglichen Bauteils muss daher der Plasmastrahl entweder über das Bauteil geführt werden, oder das Bauteil muss relativ zum Plasmastrahl bewegt werden. In beiden Fällen sind aufwendige Vorrichtungen notwendig um das Bauteil und den Plasmastrahl während der Plasmabehandlung relativ zueinander zu bewegen.

Bekannte Verfahren weisen den Nachteil auf, dass mit ihnen keine gleichmäßige Beschichtungen über die gesamte Länge und den gesamten Umfang auf längliche Bauteile aufgebracht können. Darüber hinaus sind die für die Beschichtung der länglichen Bauteile notwendigen Prozesskammern groß. Die Evakuierung der Prozesskammer ist aufgrund des großen Volumens mit einem hohen Aufwand an Zeit und Energie verbunden. Derartige gleichmäßige Beschichtungen sind beispielsweise bei Glasrohren notwendig, welche einer thermosolaren Anwendung zugeführt werden sollen. Hier können Unterschiede in der Schichtdicke von einigen wenigen Nanometem die Funktion des Bauteils in negativer Weise beeinflussen.

Der Erfindung liegt die Aufgabe zugrunde, eine Vorrichtung zur Plasmabeschichtung von länglichen, zylindrischen Bauteilen zur Verfügung zu stellen, mit der eine gleichmäßige Beschichtung über die gesamte Länge und den gesamten Umfang auf das Bauteil aufgetragen werden kann, und die mit einem geringen Aufwand an Zeit und Energie betrieben werden kann.

JP63-100181 A offenbart eine Vorrichtung zur Plasmabeschichtung von länglichen, zylindrischen Bauteilen mit Prozesskammern (3,4), vier koaxialen Transferkammern (1,2,5,6), Vakuumpumpen (10-15) angeschlossen an Prozesskammern und Transferkammern, Absperrorgane (9) zwischen Prozesskammern und Transferkammern, ein Plasmabrenner in der Prozesskammer (4) dessen Plasmastrahl senkrecht gegen die Längsachsen der Transferkammern (1,2,5,6) gerichtet ist und eine Transporteinrichtung (11) in den Transferkammern (1,2,5,6) um das Bauteil der Prozesskammer (1) zuzuführen und aus der Prozesskammer (1) abzuführen. Die Transporteinrichtung ist mit mehreren Rollenpaaren auf unterschiedlichen Rotationsachsen ausgestattet.

### Die Erfindung und ihre Vorteile

Die erfindungsgemäße Vorrichtung mit den Merkmalen des Anspruchs 1 hat den Vorteil, dass die länglichen Bauteile mit einer Transporteinrichtung relativ zu dem Plasmabrenner transportiert werden, und dass die mit dem Plasmabrenner ausgestattete Prozesskammer wesentlich kleiner und kürzer ist als die Bauteile. Die Transporteinrichtung ermöglicht eine gleichmäßige Beschichtung des Bauteils über die gesamte Länge und den gesamten Umfang. Hierzu wird das längliche Bauteil durch die Transporterinrichtung nicht nur in axialer Richtung bzw. in seiner Längsrichtung bewegt sondern zusätzlich dazu um seine Längsachse gedreht. Die beiden Bewegung können überlagert sein. Vorteilhafterweise wird das Bauteil durch die Transporteinrichtung einer schraubenförmigen Bewegung unterzogen. Die Transporteinrichtung sorgt dafür, dass die Bewegung mit konstanter und vorgegebener Geschwindigkeit erfolgt. Damit wird jeder Bereich der Oberfläche des Bauteils dem Plasmastrahl des Plasmabrenners über eine vorgegebene Dauer ausgesetzt. Dies führt zu einer gleichmäßigen Beschichtung der gesamten Oberfläche.

Zusätzlich zu der den Plasmabrenner enthaltenden Prozesskammer sind zwei Transferkammern vorgesehen. Die Kammern sind mit einer oder mehreren Pumpen zum Evakuieren ausgestattet. Die Pumpen der Prozesskammer und der Transferkammem arbeiten unabhängig voneinander. Jede der beiden Transferkammern ist über ein Absperrorgan mit der Prozesskammer verbunden. Die beiden Transferkammem sind länglich. Ihre Längsachsen verlaufen koaxial.

Vorteilhafterweise ist die Prozesskammer an ihrer Außenseite gekühlt, zum Beispiel mit Wasser. Auf diese Weise wird verhindert, dass sich die Prozesskammer und die an die Prozesskammer angeschlossenen Transferkammem zu sehr erwärmen.

Zur Beschichtung wird zunächst die Prozesskammer evakuiert. Die Absperrorgane zwischen der Prozesskammer und den beiden Transferkammem sind geschlossen. Der für die Plasmabeschichtung notwendige Druck von beispielsweise 10 bis 1.000 Pa ist aufgrund des kleinen Volumens der Prozesskammer rasch eingestellt. Anschließend wird der Plasmabrenner aktiviert und das Plasma in der Prozesskammer gezündet. Die für die Beschichtung notwendige Plasmazusammmensetzung wird eingestellt. Dann wird in die erste Transferkammer ein Bauteil eingebracht. Das Bauteil wird von der Transporteinrichtung in der ersten Transferkammer erfasst und vollständig in die erste Transferkammer aufgenommen. Sobald das Bauteil komplett in der ersten Transferkammer enthalten ist, wird die erste Transferkammer gegen die Atmosphäre verschlossen und durch die Pumpen evakuiert. Sobald ein vorgegebener Grenzwert des Drucks unterschritten ist, öffnet das Absperrorgan zwischen der ersten Transferkammer und der Prozesskammer. Vorteilhafterweise wird nun die Pumpe von der ersten Transferkammer entkoppelt. Der Druck in der ersten Transferkammer wird nun von der oder den Pumpen der Prozesskammer aufrechterhalten. Das Transportsystem transportiert anschließend das Bauteil von der ersten Transferkammer in die Prozesskammer und führt das Bauteil an dem Plasmastrahl des Plasmabrenners vorbei. Währenddessen wird die zweite Transferkammer gegen die Atmosphäre verschlossen und durch die Pumpen evakuiert. Sobald ein vorgegebener Grenzwert des Drucks unterschritten ist, öffnet das Absperrorgan zwischen der zweiten Transferkammer und der Prozesskammer, Das Bauteil kann nun durch die Transporteinrichtung von der Prozesskammer in die zweite Transferkammer transportiert werden. Sobald das Bauteil vollständig die erste Transferkammer passiert hat, wird das Absperrorgan zwischen der Prozesskammer und der ersten Transferkammer geschlossen, die erste Transferkammer belüftet und ein weiteres Bauteil in die erste Transferkammer eingebracht. Nachdem die Beschichtung der ersten Bauteils abgeschlossen ist und das Bauteil die Prozesskammer verlassen hat, wird das Absperrorgan, welches die Prozesskammer und die zweite Transferkammer trennt, geschlossen. Die zweite Transferkammer wird nun belüftet, die zweite Transferkammer geöffnet und das beschichtete Bauteil entnommen. Dieser Vorgang wird mit den nachfolgenden Bauteilen wiederholt. Hierzu muss das Plasma nicht erneut gezündet und die Zusammensetzung der Beschichtungsstoffe nicht erneut eingestellt werden. Da die Bauteile nacheinander durch die Prozesskammer geführt werden, kann der Plasma solange gezündet bleiben, bis der Beschichtungsvorgang beendet ist.

Um die Anzahl der pro Zeiteinheit beschichteten Bauteile zu erhöhen, können zusätzlich zu der ersten und zweiten Transferkammer weitere Transferkammem an der Prozesskammer angeordnet sein.

Die Beschichtungsanlage kann mit verschiedenen Plasmageneratoren oder Plasmabrennern ausgestattet sein, welche den mittels einer Zufuhreinrichtung zugeführten Beschichtungswerkstoff verdampfen, gegebenenfalls chemisch umsetzen und auf die Bauteile aufbringen. Vorteilhafterweise ist ein Gleichstrom-Plasmagenerator und/ oder ein induktiv beheizter Plasmagenerator vorgesehen.

Der Plasmabrenner ist derart in die Prozesskammer eingesetzt, dass der Plasmastrahl des Plasmabrenners unter einem Winkel von mehr als 0° und weniger als 180° gegen die beiden koaxialen Längsachsen der ersten und zweiten Transferkammer gerichtet ist. Dadurch wird gewährleistet, dass der Plasmastrahl seitlich auf die Bauteile trifft. Besonders bevorzugt ist ein Winkel von 90° zwischen den koaxialen Längsachsen und dem Plasmastrahl.

Nach einer vorteilhaften Ausgestaltung der Erfindung ist die Prozesskammer T-förmig ausgebildet mit einem ersten Anschlussteil mit erstem Absperrorgan für die erste Transferkammer, mit einem zweiten Anschlussteil mit zweitem Absperrorgan für die zweite Transferkammer und mit einem dritten Anschlussteil für den Plasmabrenner. Dank der T-Form kann die Prozesskammer besonders klein ausgeführt sein und lediglich das Volumen aufweisen, das für den Transport der Bauteile und den Plasmabrenner notwendig ist.

Nach einer weiteren vorteilhaften Ausgestaltung der Erfindung ist die Öffnung des ersten und/ oder zweiten Absperrorgans nur wenige größer, insbesondere 1 bis 10% größer ist als die Querschnittsfläche der zu beschichtenden Bauteile. Auf diese Weise tritt in der Prozesskammer keine starke Druckänderung ein, wenn das Absperrorgan geöffnet sind.

Nach einer weiteren vorteilhaften Ausgestaltung der Erfindung ist die erste und/oder zweite Transferkammer hinsichtlich ihres Volumens 1 bis 20%, besonders bevorzugt 5 bis 10% größer ist als das Volumen der zu beschichtenden Bauteile. Auf diese Weise ist das Volumen der Transferkammern klein. Der Vorgang des Evakuierens der Transferkammern erfolgt damit schnell und energiesparend.

Nach einer weiteren vorteilhaften Ausgestaltung der Erfindung ist die Länge der ersten und/ oder zweiten Transferkammer größer als die Länge der zu beschichtenden Bauteile. Auf diese Weise wird gewährleistet, dass die Bauteile vollständig in die Transferkammem aufgenommen sind, bevor die Transferkammem gegen Atmosphärendruck geöffnet oder geschlossen werden. Ferner werden die Absperrorgane zwischen der Prozesskammer und der ersten und/oder zweiten Transferkammer erst geöffnet, wenn die ein Bauteil enthaltenden Transferkammem gegen die Atmosphäre geschlossen und evakuiert sind.

Nach einer weiteren vorteilhaften Ausgestaltung der Erfindung ist der Plasmabrenner ein Gleichstrom-Plasmabrenner. Er weist eine Anode und eine Kathode auf, welche koaxial zueinander angeordnet sind.

Nach einer weiteren vorteilhaften Ausgestaltung der Erfindung ist der Plasmabrenner ein induktiver Plasmabrenner. Er ist mit einem hochfrequenten elektromagnetischen Wechselfeld betrieben.

Nach einer weiteren vorteilhaften Ausgestaltung der Erfindung ist in der Prozesskammer mindestens ein Staukörper angeordnet. Der Plasmastrahl des Plasmabrenners ist auf die Oberfläche des Staukörpers gerichtet Aus dem Plasmagenerator strömt das Plasma mit Überschallgeschwindigkeit in die Prozesskammer. Durch einen oder mehrere Staukörper wird erreicht, dass sich in der Prozeßkammer um das Bauteil herum eine homogene Plasmawolke ausbildet. Die Form, die Anordnung und die Größe des Staukörpers kann an die Anforderungen der jeweiligen Schichtsysteme angepasst werden. Dabei spielen der Druck in der Prozesskammer, der Massendurchsatz durch den Plasmabrenner, die Ausströmgeschwindigkeit aus dem Plasmabrenner und die elektrische Leistung des Plasmagenerators eine sehr wichtige Rolle. Diese Größen bestimmen das Strömungsfeld in der Prozesskammer maßgeblich. Für jede Beschichtungsaufgabe wird, beim Übergang von der Entwicklung, in die Produktion, dieses System im Hinblick auf Schichtqualität und Wirtschaftlichkeit optimiert. Wesentliche Eigenschaften des Staukörper sind: ein Schutz empfindlicher Bauteile vor Hitzeeinwirkung, ein Aufheizen des Staukörpers, so dass in seinem Staupunkt die Plasma-Beschichtungsstoffwolke nochmals aufgeheizt wird, ein Unterdruckgebiet im Nachlauf hinter dem Staukörper, in das der Beschichtungsstoff hineingesaugt wird.

Vorteilhafterweise ist der Staukörper zwischen dem Plasmabrenner und den zu beschichtenden Bauteilen in der Prozesskammer angeordnet. Zusätzlich dazu besteht die Möglichkeit, weitere Staukörper zum Beispiel seitlich von den zu beschichtenden Bauteilen in der Prozesskammer anzuordnen, um die Strömung zum Bauteil hin umzulenken.

Die Temperatur des Staukörpers hängt auch von seiner Form ab. Der Staukörper kann rund oder eckig sein. Er kann innen hohl oder massiv ausgebildet sein. Es sind zylindrische, quaderförmige, keilförmige oder kegelförmige Staukörper möglich. Staukörper, die mit einer Spitze in Richtung des Plasmastrahls weisen, werde heißer als stumpfe Körper. So kann die Temperatur im Staupunktsbereich des Staukörpers beeinflusst werden und damit die Bedingungen in der Plasmawolke hinter dem Staukörper optimiert werden.

Nach einer weiteren vorteilhaften Ausgestaltung der Erfindung besteht der Staukörper aus einem gegen den Plasmastrahl und das Beschichtungsmaterial inerten Material. Dadurch wird gewährleistet, dass der Staukörper nicht in dem Plasmastrahl reagiert und damit nicht die Zusammensetzung der Beschichtung beeinflusst.

Nach einer weiteren vorteilhaften Ausgestaltung der Erfindung ist die Transporteinrichtung mit mehreren Rollen ausgestattet. Vorteilhafterweise weist die Transporteinrichtung mehrere Rollenpaare auf. Jedes Rollenpaar ist mit mindestens zwei Rollen ausgestattet, die beide an einer Rotationsachse angeordnet sind. Ein Rotationsantrieb treibt die Rotationsachsen der Rollenpaare an. Die Rollenpaare sind hintereinander, mit einem vorgegebenen Abstand zueinander im unteren Bereich der ersten und der zweiten Transferkammer angeordnet. Sie sind vorteilhafterweise entlang einer Geraden positioniert, die parallel zur Längsachse der ersten und zweiten Transferkammer verläuft. Die Rollen sind mit einer Oberfläche mit hohem Reibwert ausgestattet. Die Oberfläche besteht zum Beispiel aus Silikon. Das Bauteil liegt auf den Rollen auf. Die Rotation der Rollen und die Reibung zwischen dem Bauteil und den Rollen führt dazu, dass die Rotationsbewegung auf das Bauteil übertragen wird und eine Translationsbewegung des Bauteils in Längsrichtung bewirkt.

Nach einer weiteren vorteilhaften Ausgestaltung der Erfindung verlaufen die Rotationsachsen aller Rollenpaare parallel zueinander. Es ist eine Einstelleinrichtung zum Einstellen des Winkels vorgesehen, unter dem die Rotationsachsen der Rollenpaare gegen die Längsachse der ersten und/ oder zweiten Transferkammer ausgerichtet sind. Durch einen von 90° verschiedenen Winkel wird zusätzlich zu der Translationsbewegung eine Rotationsbewegung der Bauteile um ihre eigene Längsachse erzielt. Diese schraubenförmige Bewegung sorgt für eine gleichmäßige Beschichtung.

Nach einer weiteren vorteilhaften Ausgestaltung der Erfindung ist die Prozesskammer mit einer zusätzlichen Transporteinrichtung ausgestattet. Diese ist insbesondere bei kleinen Bauteilen von Vorteil.

Weitere Vorteile und vorteilhafte Ausgestaltungen der Erfindung sind der nachfolgenden Beschreibungen, der Zeichnung und den Ansprüchen zu entnehmen.

### Zeichnung

In der Zeichnung ist ein Ausführungsbeispiel einer erfindungsgemäßen Vorrichtung zur Plasmabeschichtung dargestellt. Im folgenden ist diese Vorrichtung erläutert. Es zeigen:
- Figur 1: Vorrichtung zur Plasmabeschichtung in perspektivischer Ansicht,
- Figur 2: Vorrichtung zur Plasmabeschichtung gemäß Figur 1 in einer Ansicht von der Seite,
- Figur 3: Vorrichtung zur Plasmabeschichtung gemäß Figur 1 in einer Ansicht von oben,
- Figur 4: Transporteinrichtung der Vorrichtung gemäß Figur 1 in perspektivischer Ansicht,
- Figur 5: Transporteinrichtung gemäß Figur 4 in einer Ansicht von unten,
- Figur 6: Prozesskammer der Vorrichtung gemäß Figur 1 in einer Ansicht von vorne,
- Figur 7: Gleichstrom-Plasmabrenner der Vorrichtung gemäß Figur 1 in einer Seitenansicht,
- Figur 8: Prinzipskizze eines weiteren Ausführungsbeispiels eines Gleichstrom-Plasmabrenners mit verschiedenen Expansionsstufen,
- Figur 9: drittes Ausführungsbeispiel eines Gleichstrom-Plasmabrenners mit nachgeschalteter induktiver Stufe.

### Beschreibung des Ausführungsbeispiels

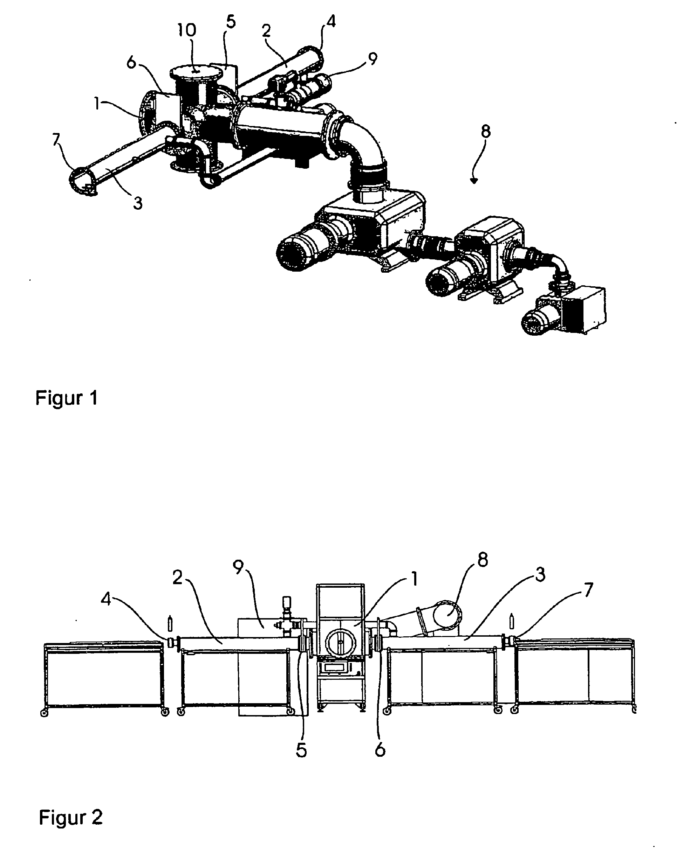

Die Figuren 1, 2 und 3 zeigen eine Vorrichtung zur Plasmabeschichtung in verschiedenen Ansichten. Die erfindungsgemäße Vorrichtung besteht im wesentlichen aus einer Prozesskammer 1, einer ersten Transferkammer 2, einer zweiten Transferkammer 3 und einem Plasmabrenner bzw. Plasmagenerator 10. Die erste Transferkammer 2 ist über einen Vakuum-Schieber 5 mit der Prozesskammer 1 verbunden. An dem der Prozesskammer 1 abgewandten Ende 4 der ersten Transferkammer 2 ist ebenfalls ein in der Zeichnung nicht dargestellter Vakuum-Schieber angeordnet, um die erste Transferkammer gegen den Atmosphärendruck abzudichten. Die zweite Transferkammer 3 ist über einen Vakuum-Schieber 6 mit der Prozesskammer 1 verbunden. An dem der Prozesskammer 1 abgewandten Ende 7 der zweiten Transferkammer 3 ist ebenfalls ein in der Zeichnung nicht dargestellter Vakuum-Schieber angeordnet, um die zweite Transferkammer gegen den Atmosphärendruck abzudichten. Die Prozesskammer 1 ist mit einem dreistufigen Vakuumsystem bestehend aus drei Pumpen 8 verbunden. Die Pumpen halten den Druck in der Prozesskammer 1 während des Beschichtungsvorgangs auf einem Niveau zwischen 10 und ca. 1.000 Pa hält. Das Pumpsystem besteht aus einer Drehschieber- oder Drehkolbenpumpe und zwei Rootspumpen. Der Druck kann entsprechend den Anforderungen für eine optimale Beschichtung vorgewählt werden.

Die erste und zweite Transferkammer 2 und 3 sind mit einem separaten Vakuumsystem verbunden, welches aus einer Pumpe 9 besteht. Diese hat die Aufgabe, die Transferkammern abwechselnd zu evakuieren. Die Pumpe 9 ist hierfür mit beiden Transferkammem 2 und 3 verbunden. Zur Trennung von Transferkammern und Pumpe sind Vakuumschieber oder -ventile zwischen die beiden Transferkammem 2 und 3 und die Pumpe 9 geschaltet. Diese sind in der Zeichnung nicht dargestellt.

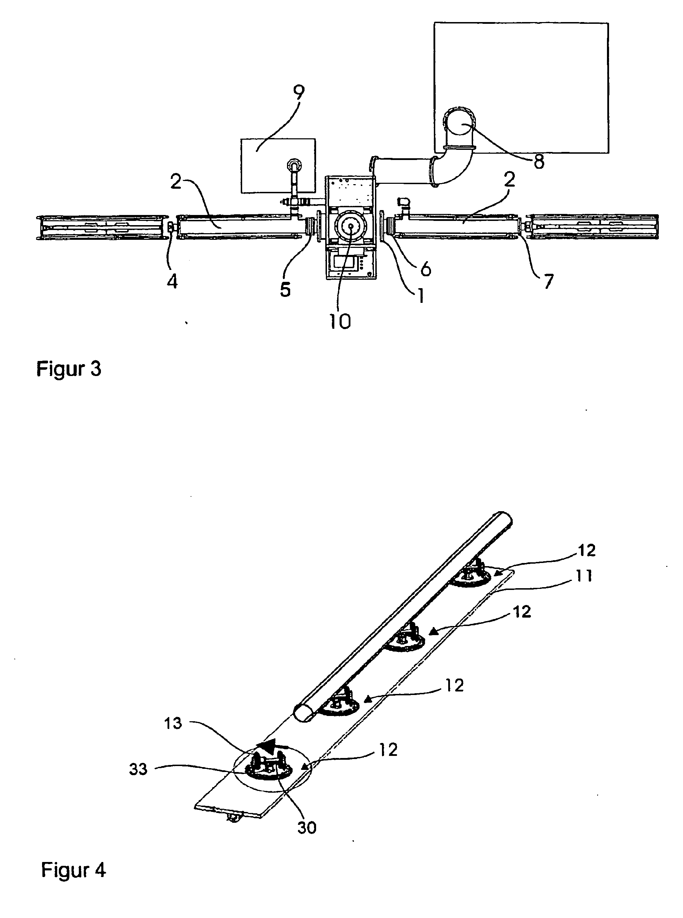

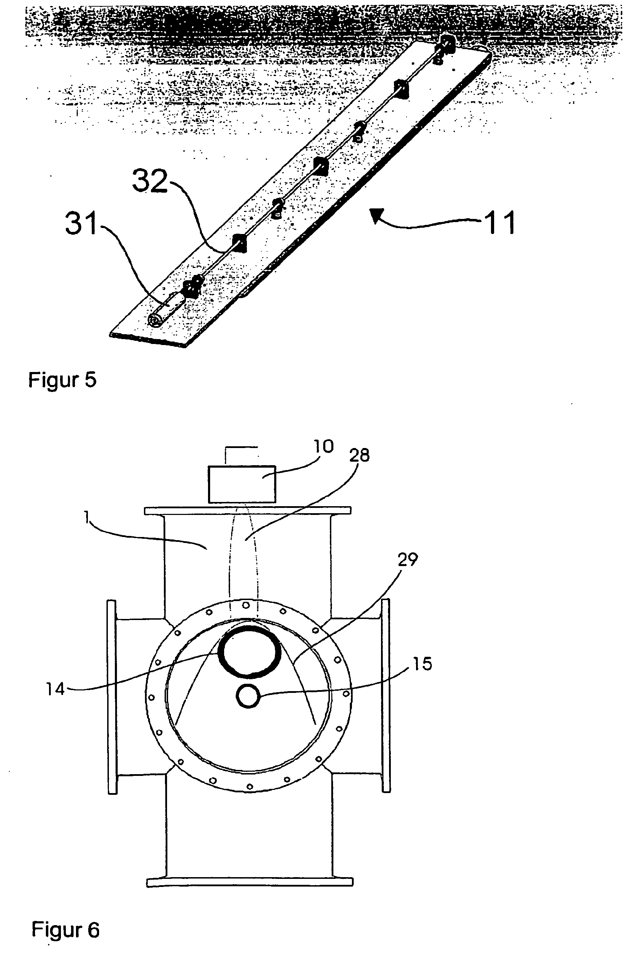

In Figur 4 und 5 ist die Transporteinrichtung 11 perspektivisch dargestellt, die die rohrförmigen Bauteile 15 transportiert. Diese Transporteinrichtung ist in der ersten und der zweiten Transferkammer 2 und 3 angeordnet. Die Transporteinrichtung 11 weist mehrere Rollenpaare 12 auf, die aus jeweils zwei Rollen 13 und einer gemeinsamen Rotationsachse 30 bestehen. Die Rotationsachsen 30 werden durch einen an der Unterseite der Transporteinrichtung 11 angeordneten Rotationsantrieb 31 und eine Antriebswelle 32 zur Rotation angetrieben. Der Antrieb wird über die Antriebswelle 32, mit der alle Rollenpaare verbunden sind, synchronisiert. Alle Rollenpaare 12 sind um eine vertikale Achse 33 drehbar, so dass der Winkel, unter dem die Rotationsachse 30 gegen die Längsachse des Bauteils 15 und der Transferkammer ausgerichtet ist, eingestellt werden kann. Dank dieses Winkels beschreibt das Bauteil beim Transport eine schraubenförmige Bewegung, die sich aus einer Translationsbewegung in Richtung der Längsachse des Bauteils und einer Rotationsbewegung um die Längsachse des Bauteils zusammensetzt. Der Winkel der Rollenpaare kann stufenlos eingestellt werden. Dadurch kann die Steigung der Schraubenlinie stufenlos eingestellt werden und so neben der Gleichmäßigkeit auch Einfluss auf die Beschichtungsgeschwindigkeit genommen werden.

Figur 6 zeigt die Prozesskammer 1 mit dem Plasmabrenner 10, einem rohrförmigen Staukörper 14 und einem rohrförmigen Bauteil 15. Der Staukörper 14 ist ortsfest in der Prozesskammer angeordnet. Die Bauteile 15 werden durch eine Transporteinrichtung 11 gemäß Figur 4 und 5 transportiert. Der Plasmastrahl 28 des Plasmabrenners 10 erzeugt beim Auftreffen auf den Staukörper 14 eine Plasmawolke 29, die sich positiv auf die Beschichtung auswirkt.

Die Vorrichtung kann mit verschiedenen Plasmageneratoren bzw. Plasmabrennern ausgestattet werden, welche den mittels einer Zufuhreinrichtung zugeführten Beschichtungswerkstoff verdampfen, gegebenenfalls chemisch umsetzen und auf die rohrförmigen Bauteile aufbringen.

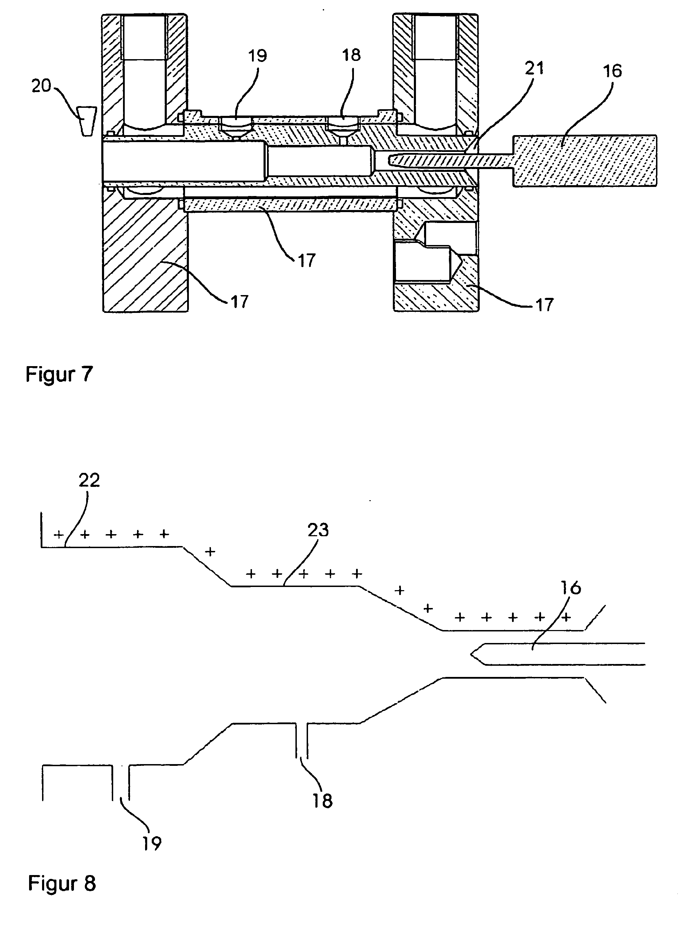

Figur 7 zeigt einen Gleichstrom-Plasmabrenner mit einer stabförmigen Kathode 16, die aus thoriertem Wolfram hergestellt ist, und einer koaxial dazu angeordneten, wassergekühlten Anode 17 aus Kupfer. Entsprechend der Beschichtungsaufgabe kann das Plasmagas mit Unterschall oder Überschall durch den Plasmagenerator strömen. Zusätzlich besteht die Möglichkeit das Plasmagas drallbehaftet durch den Plasmagenerator strömen zu lassen. Ebenso kann die wassergekühlte Anode 17 konturiert werden, um die Strömung im Plasmagenerator zu beschleunigen. Mit diesen Maßnahmen kann die Strömung im Plasmafreistrahl gezielt beeinflusst werden. Zusammen mit den oben beschriebenen Staukörpern wird so erreicht, dass um das Werkstück eine homogene Plasmawolke aus Trägergas und verdampftem Beschichtungswerkstoff entsteht. In Kombination mit der Fördereinrichtung wird auf diese Weise eine homogene Beschichtung der Bauteile erzielt. Bei geeigneter Auslegung können so Schichten in hoher Qualität mit sehr großen Beschichtungsgeschwindigkeiten abgeschieden werden.

Figur 7 zeigt außerdem verschiedene Zufuhreinrichtungen 18, 19. 20 für die Einspeisung von Beschichtungswerkstoffen in den Plasmafreistrahl. Derjenige Teil des Plasmastrahls, der außerhalb des Plasmagenerators verläuft, wird als Plasmafreistrahl bezeichnet. Je nach Aggregatszustand, fest, flüssig oder gasförmig, beziehungsweise entsprechend der Energie, die für die Aufbereitung der Beschichtungswerkstoffe benötigt wird, können die Beschichtungswerkstoffe an verschiedenen Punkten in den Plasmagenerator beziehungsweise in den Plasmastrahl eingespeist werden. Für Stoffe, die sehr große Energie benötigen, um in einen für die Beschichtung optimalen Zustand gebracht zu werden, kann die Einspeisung direkt in den Kernstrahl, das heißt die heiße Zone direkt vor der Kathodenspitze, erfolgen. Eine derartige Zufuhreinrichtung 18 bringt das Beschichtungsmaterial in den Bereich des Plasmastrahls mit der höchsten Energiedichte. Darüber hinaus ist es möglich, durch eine zweite Zufuhreinrichtung 19 die Einspritzung des Beschichtungswerkstoffs in einer Zone geringerer Energiedichte stromabwärts im Kernstrahl zuzuführen. Leicht flüchtige Stoffe können durch eine dritte Zufuhreinrichtung 20 außerhalb des Plasmagenerators in den Plasmafreistrahl zugeführt werden. Darüber hinaus kann der Plasmazustand im Plasmagenerator und im Plasmafreistrahl durch eine entsprechende Konturierung beeinflusst werden. Für diesen Zweck ist der Plasmabrenner modular aufgebaut.

Der Gleichstrom-Plasmagenerator kann so ausgestaltet sein, dass ein Arbeitgas zunächst auf eine sehr hohe Temperatur aufgeheizt wird. Anschließend wird das Plasma auf den Druck, der in der Prozesskammer herrscht, entspannt. Je nach Beschichtungsaufgabe können dem Plasmastrom innerhalb des Gleichstrom-Plasmagenerators verschiedene Stoffe beigemischt werden. Dabei werden die Temperaturen und Drücke, die im Plasmagenerator herrschen, entsprechend der chemischen Anforderungen, die sich aus der jeweiligen Beschichtungsaufgabe ergeben, eingestellt. Neben der oben beschriebenen Einstellung durch die Wahl des Abstands der Einspritzpunkte von der Kathodenspitze erfolgt die Einstellung auch durch die Wahl der Gasflüsse, der Gleichstrom-Leistung und durch eine geeignete Konturierung des Strömungskanals im Gleichstrom-Plasmagenerator. Im Strahlkern des Gleichstrom-Plasmagenerators können Temperaturen von 10.000 bis 20.000 K erreicht werden. Verschiedene Expansionsstufen 22 und 23 sind gemäß Figur 8 für die Zumischung verschiedener Stoffe vorgesehen. Den Expansionsstufen kann eine Mischkammer nachgeschaltet werden, so dass eine Doppel-Lavaldüse vorliegt. Die Mischkammer kann bei Bedarf als Anode geschaltet werden. Dadurch kann die Temperatur im Plasmagenerator hochgehalten werden. Außerdem können auf diese Weise die chemischen Reaktionen im Plasmagenerator gesteuert werden. Durch Wahl des geeigneten Expansionsverhältnisses wird dafür gesorgt, dass kein Beschichtungsstoff zur Kathode zurückströmt. Das so erzeugte Beschichtungsplasma tritt dann, nachdem es durch Expansion abgekühlt wurde, in der oben beschriebenen Weise mit dem zu beschichtenden Bauteil in Wechselwirkung.

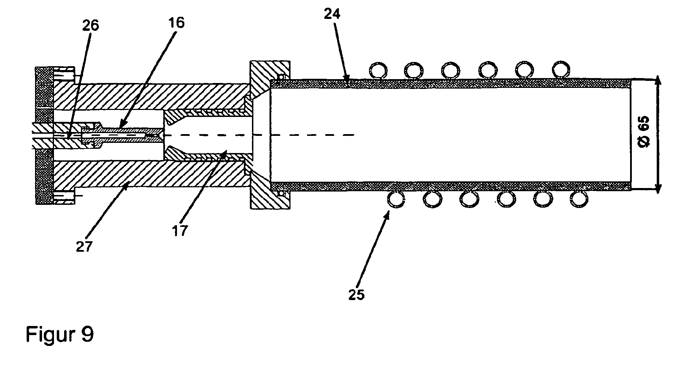

Für Anwendungen mit Gasen und Stoffgemischen, die unter Umständen die Kathode des Gleichstrom-Plasmagenerators angreifen, kann der Gleichstromgenerator durch eine induktiv beheizte Plasmaquelle ersetzt werden. Dies ist in Figur 9 dargestellt. Diese Plasmaquellen koppeln die Energie induktiv in einen Gasstrom ein. Für diesen Fall wird ein rohrförmiges Entladungsgefäß 24 aus dielektrischem Material von einer wassergekühlten Spule 25 aus Kupfer umgeben. Durch die Spule fließt ein hochfrequenter Wechselstrom. Dadurch bildet sich im Innem der Röhre ein oszillierendes Magnetfeld aus. Dieses induziert ein azimuthales elektrisches Feld, welches für die Zündung und Unterhaltung der Entladung verantwortlich ist. Im Gegensatz zu den weiter verbreiteten lichtbogenbeheizten Plasmaquellen erfolgt hier die Einkopplung elektrodenlos. Das heißt, stromführende metallische Bauteile kommen nicht mit dem Plasma in Berührung. Damit ist der Einfluss der Erosion der Elektroden prinzipiell ausgeschlossen. Kohlenstoff- und sauerstoffhaltige Stoffen können eingesetzt werden.

Für Anwendungen, die besonders große Leistungsdichten im Plasma verlangen, steht zusätzlich ein Hybridplasmagenerator zur Verfügung. Unter Hybridplasmageneratoren soll in diesem Zusammenhang die Überlagerung zweier unterschiedlicher Arten der Einkopplung von Energie in das Arbeitsgas betrachtet werden. Damit wird eine Möglichkeit geschaffen, durch Zufuhr zusätzlicher Energie und/ oder zusätzlicher Masse in den Plasmastrahl die Eigenschaften des Plasmas im Freistrahl und an der Oberfläche eines zu beschichtenden Werkstücks gezielt zu beeinflussen. Im vorliegenden Fall wird die induktive Plasmaquelle einem Gleichstrom-Plasmagenerator nachgeschaltet.

### Bezugszeichen

- 1: Prozeßkammer
- 2: erste Transferkammer
- 3: zweite Transferkammer
- 4: der Prozesskammer abgewandtes Ende der ersten Vakuumkammer
- 5: Vakuumschieber
- 6: Vakuumschieber
- 7: der Prozesskammer abgewandtes Ende der zweiten Transferkammer
- 8: Pumpensystem der Prozesskammer
- 9: Pumpensystem der Transferkammem
- 10: Plasmagenerator
- 11: Transporteinrichtung
- 12: Rollenpaar
- 13: Rolle
- 14: Staukörper
- 15: Bauteil
- 16: Kathode
- 17: Anode
- 18: Zufuhreinrichtung für Beschichtungswerkstoff
- 19: Zufuhreinrichtung für Beschichtungswerkstoff
- 20: Zufuhreinrichtung für Beschichtungswerkstoff
- 21: Gasdüse zur Beschleunigung der Gasströmung im Plasmagenerator
- 22: erste Expansionsstufe
- 23: zweite Expansionsstufe
- 24: Dielektrisches Rohr
- 25: Induktionsspule
- 26: Kontainment
- 27: Kathodenhalter
- 28: Plasmastrahl
- 29: Plasmawolke
- 30: Rotationsachse
- 31: Rotationsantrieb
- 32: Antriebswelle
- 33: vertikale Achse

## Patentansprüche

1. Vorrichtung zur Plasmabeschichtung von länglichen, zylindrischen Bauteilen, insbesondere rohrförmigen Bauteilen,
mit einer Prozesskammer (1) mit einer oder mehreren Pumpen (8) zur Evakuierung der Prozesskammer (1),
mit einer ersten länglichen Transferkammer (2), welche durch ein erstes Absperrorgan (5) mit der Prozesskammer (1) verbunden ist,
mit einer oder mehreren Pumpen (9) der ersten Transferkammer (2) zur Evakuierung der ersten Transferkammer (2),
mit einer zweiten länglichen Transferkammer (3), welche durch ein zweites Absperrorgan (6) mit der Prozesskammer (1) verbunden ist, und deren Längsachse koaxial zu derjenigen der ersten Transferkammer verläuft (2),
mit einer oder mehreren Pumpen (9) der zweiten Transferkammer (3) zur Evakuierung der zweiten Transferkammer (3),
mit einem Plasmabrenner (10) in oder an der Prozesskammer (1), dessen Plasmastrahl unter einem von 0° und 180° verschiedenen Winkel gegen die Längsachsen der ersten und zweiten Transferkammer (2, 3) gerichtet ist,
mit einer Zufuhreinrichtung (18, 19, 20) in der Prozesskammer (1) für die Zufuhr des Beschichtungswerkstoffs in den Plasmastrahl,
mit einer Transporteinrichtung (11) in der ersten und/ oder der zweiten Transferkammer (2, 3) um das Bauteil der Prozesskammer (1) zuzuführen und aus der Prozesskammer (1) abzuführen,
wobei die Transporteinrichtung (11) mit mehreren Rollenpaaren (12) ausgestattet ist.
wobei jedes Rollenpaar (12) mit mindestens zwei Rollen (13) ausgestattet ist, die beide an einer Rotationsachse (30) angeordnet sind, und ein Rotationsantrieb (31) zum Antreiben der Rotationsachsen (30) der Rollenpaare (12) vorgesehen ist,
dadurch _gekennzeichnet,
dass der Rotationsantrieb über eine Antriebswelle (32), mit der alle Rollenpaare (12) verbunden sind, synchronisiert ist,
dass alle Rollenpaare um eine vertikale Achse (33) drehbar sind.

2. Vorrichtung nach Anspruch 1, **dadurch gekennzeichnet, dass** die Prozesskammer (1) T-förmig ist mit einem ersten Anschlussteil mit erstem Absperrorgan (5) für die erste Transferkammer (2), mit einem zweiten Anschlussteil mit zweitem Absperrorgan (6) für die zweite Transferkammer (3) und mit einem dritten Anschlussteil für den Plasmabrenner (10).

3. Vorrichtung nach einem der vorhergehenden Ansprüche, **dadurch gekennzeichnet, dass** der Plasmabrenner (10) ein Gleichstrom-Plasmabrenner ist und eine Anode (17) und eine Kathode (16) aufweist, welche koaxial zueinander angeordnet sind.

4. Vorrichtung nach einem der vorhergehenden Ansprüche, **dadurch gekennzeichnet, dass** der Plasmabrenner ein induktiver Plasmabrenner ist und mit hochfrequentem elektromagnetischen Wechselfeld betrieben ist.

5. Vorrichtung nach einem der vorhergehenden Ansprüche, **dadurch gekennzeichnet, dass** in der Prozesskammer (1) mindestens ein Staukörper (14) angeordnet ist und dass der Plasmastrahl (28) des Plasmabrenners (10) auf die Oberfläche des Staukörpers (14) gerichtet ist.

6. Vorrichtung nach Anspruch 5, **dadurch gekennzeichnet, dass** der Staukörper (14) oberhalb der durch die koaxialen Längsachsen der ersten und zweiten Transferkammer (2, 3) gebildeten Geraden angeordnet ist.

7. Vorrichtung nach Anspruch 5 oder 6, **dadurch gekennzeichnet, dass** der Staukörper (14) aus einem gegen den Plasmastrahl inerten Material besteht.

8. Vorrichtung nach Anspruch 1, **dadurch gekennzeichnet, dass** die Rotationsachsen (30) aller Rollenpaare (12) parallel zueinander verlaufen, und dass eine Einstelleinrichtung zum Einstellen des Winkels vorgesehen ist, unter dem die Rotationsachsen gegen die Längsachse der ersten und/oder zweiten Transferkammer (2, 3) ausgerichtet sind.

9. Vorrichtung nach Anspruch 8, **dadurch gekennzeichnet, dass** die Rotationsachsen (30) gegenüber dem Boden der ersten und/ oder zweiten Transferkammer (2, 3) drehbar sind.

10. Vorrichtung nach einem der vorhergehenden Ansprüche, **dadurch gekennzeichnet, dass** die Prozesskammer (1) mit einer Transporteinrichtung ausgestattet (11) ist.

## Claims

1. Device for plasma coating of long, cylindrical components, especially tubular components,
with a processing chamber (1) with one or more pumps (8) for evacuating the processing chamber (1),
with a first long transfer chamber (2) that is connected to the processing chamber (1) through a first shut-off device (5),
with one or more pumps (9) of the first transfer chamber (2) for evacuating the first transfer chamber (2),
with a second long transfer chamber (3) that is connected to the processing chamber (1) through a second shut-off device (6), and whose longitudinal axis runs coaxially to that of the first transfer chamber (2),
with one or more pumps (9) of the second transfer chamber (3) for evacuating the second transfer chamber (3),
with a plasma torch (10) in or at the processing chamber (1) whose plasma jet is aligned opposite the longitudinal axes of the first and second transfer chambers (2, 3) at an angle that differs from 0° or 180°,
with a feeder unit (18, 19, 20) in the processing chamber (1) for feeding the coating material in the plasma jet,
with a transport device (11) in the first and/or second transfer chamber (2, 3) to feed the component to the processing chamber (1) and discharge it from the processing chamber (1),
whereby the transport device (11) is equipped with several pairs of rollers (12),
whereby each pair of rollers (12) is equipped with at least two rollers (13), both of which are arranged on a rotational axis (30), and a rotary drive (31) is provided for driving the rotational axes (30) of the pairs of rollers (12),
**characterised in that**
the rotary drive is synchronised via a drive shaft (32) with which all pairs of rollers (12) are connected,
all pairs of rollers can pivot around a vertical axis (33).

2. Device according to claim 1, **characterised in that** the processing chamber (1) is T-shaped with a first connecting part with the first shut-off device (5) for the first transfer chamber (2), with a second connecting part with the second shut-off device (6) for the second transfer chamber (3) and with a third connecting part for the plasma torch (10).

3. Device according to one of the previous claims, **characterised in that** the plasma torch (10) is a direct-current plasma torch and has one anode (17) and one cathode (16), which are coaxially aligned with one another.

4. Device according to one of the previous claims, **characterised in that** the plasma torch is an inductive plasma torch and is operated with a highfrequency electromagnetic alternating field.

5. Device according to one of the previous claims, **characterised in that** at least one damming body (14) is located in the processing chamber (1) and that the plasma jet (28) of the plasma torch (10) is oriented toward the surface of the damming body (14).

6. Device according to claim 5, **characterised in that** the damming body (14) is located above the line formed by the coaxial longitudinal axes of the first and second transfer chambers (2, 3).

7. Device according to claim 5 or 6, **characterised in that** the damming body (14) consists of a material inert against the plasma jet.

8. Device according to claim 1, **characterised in that** the rotational axes (30) of all pairs of rollers (12) run parallel to one another and that an adjustment device is provided to adjust the angle at which the rotational axes are aligned opposite the longitudinal axis of the first and/or second transfer chamber (2, 3).

9. Device according to claim 8, **characterised in that** the rotational axes (30) can be pivoted relative to the floor of the first and/or second transfer chamber (2, 3).

10. Device according to one of the previous claims, **characterised in that** the processing chamber (1) is equipped with a transport device (11).

## Revendications

1. Dispositif destiné au revêtement par plasma de composants longitudinaux et cylindriques, en particulier de composants tubulaires,
avec une chambre de process (1) dotée d'une ou de plusieurs pompes (8) pour la production du vide dans la chambre de process (1),
avec une première chambre de transfert longitudinale (2) qui est reliée à la chambre de process (1) par un premier organe d'arrêt (5),
avec une ou plusieurs pompes (9) de la première chambre de transfert (2) pour la production du vide dans la première chambre de transfert (2),
avec une deuxième chambre de transfert longitudinale (3) qui est reliée à la chambre de process (1) par un deuxième organe d'arrêt (6), et dont l'axe longitudinal est disposé coaxialement par rapport à celui de la première chambre de transfert (2),
avec une ou plusieurs pompes (9) de la deuxième chambre de transfert (3) pour la production du vide dans la deuxième chambre de transfert (3),
avec une torche à plasma (10) disposée dans ou au niveau de la chambre de process (1), le jet de plasma de cette torche étant orienté à un angle différent de 0° et de 180° par rapport aux axes longitudinaux de la première et de la deuxième chambre de transfert (2, 3),
avec un dispositif d'alimentation (18, 19, 20) dans la chambre de process (1) pour l'apport du matériau de revêtement dans le jet de plasma,
avec un dispositif de transport (11) dans la première et/ou dans la deuxième chambre de transfert (2, 3), servant à transporter le composant dans la chambre de process (1) et hors de la chambre de process (1),
ce dispositif de transport (11) étant doté de plusieurs paires de galets (12), chaque paire de galets (12) étant dotée d'au moins deux galets (13) disposés tous les deux sur un axe de rotation (30), et un entraînement rotatif (31) servant à entraîner les axes de rotation (30) des paires de galets (12) étant prévu,
**caractérisé en ce que**
l'entraînement rotatif est synchronisé au moyen d'un arbre d'entraînement (32) auquel toutes les paires de galets (12) sont reliées,
toutes les paires de galets peuvent tourner autour d'un axe vertical (33).

2. Dispositif selon la revendication 1, **caractérisé en ce que** la chambre de process (1) est en forme de T et dotée d'un premier raccord avec un premier organe d'arrêt (5) pour la première chambre de transfert (2), d'un deuxième raccord avec un deuxième organe d'arrêt (6) pour la deuxième chambre de transfert (3) ainsi que d'un troisième raccord pour la torche à plasma (10).

3. Dispositif selon l'une quelconque des revendications précédentes, **caractérisé en ce que** la torche à plasma (10) est une torche à plasma à courant continu et présente une anode (17) ainsi qu'une cathode (16) qui sont disposées coaxialement l'une par rapport à l'autre.

4. Dispositif selon l'une quelconque des revendications précédentes, **caractérisé en ce que** la torche à plasma est une torche à plasma à induction et fonctionne avec un champ alternatif électromagnétique à haute fréquence.

5. Dispositif selon l'une quelconque des revendications précédentes, **caractérisé en ce qu'**au moins un corps de retenue (14) est disposé dans la chambre de process (1) et que le jet de plasma (28) de la torche à plasma (10) est dirigé sur la surface du corps de retenue (14).

6. Dispositif selon la revendication 5, **caractérisé en ce que** le corps de retenue (14) est disposé au-dessus des droites formées par les axes longitudinaux coaxiaux de la première et de la deuxième chambre de transfert (2, 3).

7. Dispositif selon la revendication 5 ou 6, **caractérisé en ce que** le corps de retenue (14) est fait d'un matériau inerte au jet de plasma.

8. Dispositif selon la revendication 1, **caractérisé en ce que** les axes de rotation (30) de toutes les paires de galets (12) sont parallèles les uns par rapport aux autres, et qu'un dispositif de réglage est prévu pour régler l'angle avec lequel les axes de rotation sont orientés par rapport aux axes longitudinaux de la première et/ou deuxième chambre de transfert (2, 3).

9. Dispositif selon la revendication 8, **caractérisé en ce que** les axes de rotation (30) sont orientables par rapport au fond de la première et/ou de la deuxième chambre de transfert (2, 3).

10. Dispositif selon l'une quelconque des revendications précédentes, **caractérisé en ce que** la chambre de process (1) est équipée d'un dispositif de transport (11).
